Europäisches Patentamt

European Patent Office

Office européen des brevets

(11) Publication number: **0 323 843**
A2

# EUROPEAN PATENT APPLICATION

(21) Application number: 89100149.7

(22) Date of filing: 05.01.89

(51) Int. Cl.⁴: **H 01 L 27/06**
H 01 L 29/78

(30) Priority: 06.01.88 JP 1054/88

(43) Date of publication of application:
12.07.89 Bulletin 89/28

(84) Designated Contracting States: DE FR GB IT

(71) Applicant: KABUSHIKI KAISHA TOSHIBA
72, Horikawa-cho Saiwai-ku
Kawasaki-shi Kanagawa-ken 210 (JP)

(72) Inventor: Takagi, Yosuke c/o Patent Division
Kabushiki Kaisha Toshiba 1-1 Shibaura 1-chome
Minato-ku Tokyo 105 (JP)

Kitahara, Koichi c/o Patent Division
Kabushiki Kaisha Toshiba 1-1 Shibaura 1-chome
Minato-ku Tokyo 105 (JP)

Ohata, Yu c/o Patent Division
Kabushiki Kaisha Toshiba 1-1 Shibaura 1-chome
Minato-ku Tokyo 105 (JP)

(74) Representative: Ritter und Edler von Fischern,
Bernhard,Dipl.-Ing. et al
HOFFMANN - EITLE & PARTNER Arabellastrasse 4
D-8000 München 81 (DE)

(54) Multi-output vertical type power semiconductor device.

(57) A vertical type power semiconductor device having a common drain and sources and gates. The drains and sources are divided into a plurality of groups is formed in a single semiconductor substrate (11). A plurality of source electrodes (16-1, 16-2) and gate electrodes (15-1, 15-2) are provided. The plurality of source electrodes (16-1, 16-2) and gate electrodes (15-1, 15-2) are connected for each group by means of a plurality of gate electrode wirings (17-1, 17-2) and a plurality of source electrode wirings (18-1, 18-2), respectively. When control signals (S1, S2) are supplied to the gate electrodes (15-1, 15-2) in each group via gate electrode wirings (17-1, 17-2), the vertical type power semiconductor device functions as a multi-output device.

F I G. 1

EP 0 323 843 A2

## Description

## Multi-output vertical type power semiconductor device

This invention relates to a multi-output vertical type power semiconductor device, and more particularly to a vertical type power semiconductor device in which the drain thereof is commonly used and a plurality of gate electrodes and source electrodes are divided into a plurality of groups, making it possible to derive a plurality of outputs in a single chip.

A hybrid semiconductor device (which is hereinafter referred to as a power IC) which is constituted by integrating a vertical type power semiconductor device and a control circuit operated by a signal with a small amplitude to control the operation of the semiconductor device in a monolithic form on a single semiconductor substrate (chip) is known in the art. This type of power IC is disclosed in, for example, "IEEE, POWER ELECTRONICS SPECIALISTS CONFERENCE RECORD, 1985, THE DESIGN OF A HIGH POWER SOLID STATE AUTOMOTIVE SWITCH IN CMOS-VDMOS TECHNOLOGY, Robert S. Wrathall pp 229 to 233".

However, as is disclosed in the above document, the conventional vertical type power semiconductor device has a single output terminal, a plurality of chips are necessary when a plurality of loads are driven by using the power IC. That is, one chip (power IC) is necessary for each load, and when a plurality of loads are driven, the chips of the same number as the loads are required. Therefore, when the chip is mounted on a PC board for use, the mounting process will be complex, space for the mounting is required, and the number of parts will increase. Further, since elements in different chips will have different electrical and thermal characteristics, it becomes difficult to drive the loads at a high precision so that they can effect substantially the same operation.

An object of this invention is to provide a vertical type power semiconductor device in which the mounting process can be simplified, the space for the mounting can be reduced and the number of parts used can be reduced.

Another object of this invention is to provide a vertical type power semiconductor device capable of driving a plurality of loads at a high precision.

According to one embodiment of this invention, there is provided a vertical type power semiconductor device which comprises a semiconductor substrate of a first conductivity type acting as a drain region; a plurality of body regions of a second conductivity type separately formed in a first main surface area of the semiconductor substrate; source regions of the first conductivity type formed in the surface areas of the body regions and having a high impurity concentration; a plurality of gate electrodes each formed on an insulation film which is formed on that portion of the body region which lies between the surface area of the semiconductor substrate and the source region and acts as a channel region; a plurality of source electrodes formed in ohmic contact with the source regions; a drain electrode formed in ohmic contact with a second main surface of the semiconductor substrate; a plurality of gate electrode wirings for connecting the gate electrodes for each group; and a plurality of source electrode wirings for connecting the source electrodes in each of the groups divided by the gate electrode wirings.

With the above construction, since the power semiconductor device has a common drain and sources, and these sources are used as output terminals, it is possible to drive a plurality of loads by means of the devices formed on one chip. Therefore, a vertical type power semiconductor device can be provided in which a mounting process on a PC board can be simplified, space for the mounting can be reduced and the number of parts used can be reduced. Further, since a plurality of devices for driving a plurality of loads are formed on one chip, difference in the electrical and thermal characteristics of different devices may be suppressed to a minimum, thus making it possible to drive the loads at a high precision.

This invention can be more fully understood from the following detailed description when taken in conjunction with the accompanying drawings, in which:

Fig. 1 is a cross sectional view of a power MOSFET acting as a vertical type power semiconductor device according to a first embodiment of this invention;

Fig. 2 is a cross sectional view of a IGBT acting as a vertical type power semiconductor device according to a second embodiment of this invention;

Fig. 3 is a cross sectional view of a power IC acting as a vertical type power semiconductor device according to a third embodiment of this invention;

Fig. 4 is a cross sectional view of another power IC acting as a vertical type power semiconductor device according to a fourth embodiment of this invention;

Fig. 5 is a cross sectional view showing another construction of the power IC shown in Fig. 4;

Fig. 6 is a cross sectional view showing still another construction of the power IC shown in Fig. 4;

Fig. 7 is a circuit diagram for illustrating a practical example of a power IC according to this invention;

Fig. 8 is a cross sectional view for illustrating a vertical type power semiconductor device according to a fifth embodiment of this invention; and

Figs. 9A and 9B are circuit diagrams for comparing the prior art circuit and the circuit of this invention in a case where power is supplied to a plurality of loads by using the power IC.

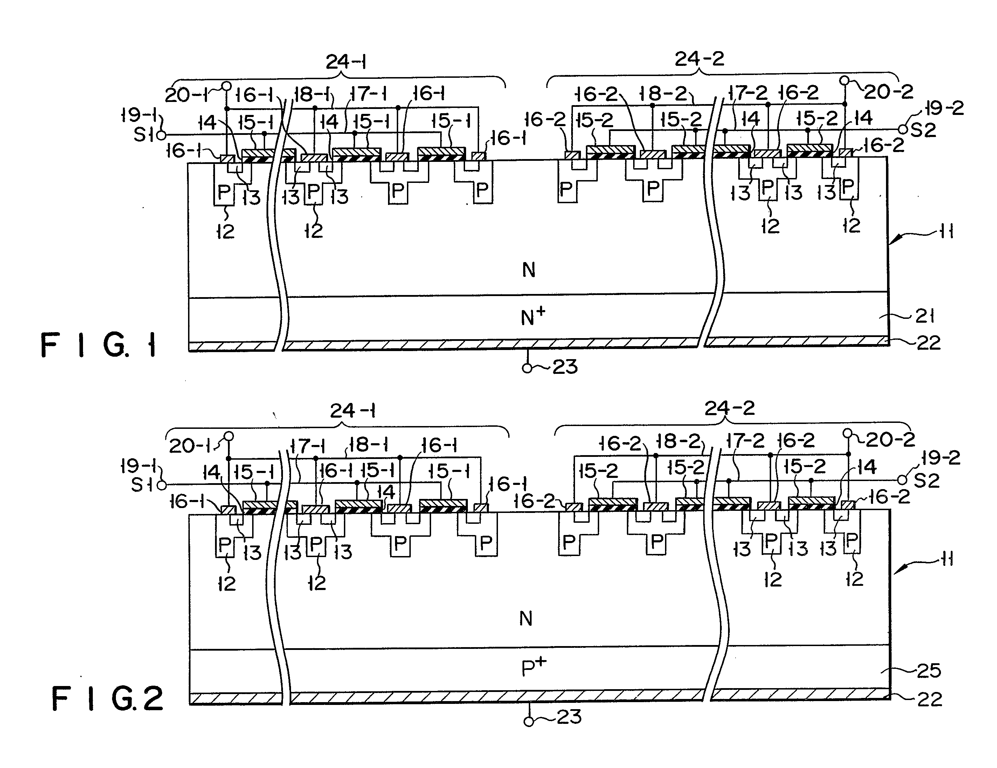

Fig. 1 shows a vertical type power semiconductor device according to a first embodiment of this invention. The device is a two-output power MOSFET in which the drain is commonly used. A plurality of P body regions 12 are separately formed in the first main surface (upper surface) area of N-type semiconductor substrate (drain region) 11. The central portion of each P body region 12 is formed to have a diffusion depth larger than the peripheral portion thereof. N$^+$-type source region or regions 13 are formed in the surface area of each P body region 12. Gate insulation films 14 are each formed on those parts of adjacent P body regions 12 which lie between the first main surface area of semiconductor substrate 11 acting as a drain high-resistance area and source regions 13, and on that part of substrate 11 which lies between adjacent P body regions 12. Gate electrodes 15-1 and 15-2 are each formed on a corresponding one of gate insulation films 14. Source electrodes 16-1 and 16-2 are each formed in ohmic contact with source region or regions 13 in a corresponding one of P body regions 12. Gate electrodes 15-1 are connected together by gate electrode wiring 17-1 of, for example, N$^+$-type polysilicon. Likewise, gate electrodes 15-2 are connected together by gate electrode wiring 17-2 of N$^+$-type polysilicon. Source electrodes 16-1 are connected together by source electrode wiring 18-1 of, for example, aluminum. Likewise, source electrodes 16-2 are connected together by source electrode wiring 18-2 of aluminum. Gate electrode wiring 17-1 is connected to gate terminal 19-1 through a wiring of, for example, aluminum, and gate electrode wiring 17-2 is connected to gate terminal 19-2 through a wiring of aluminum. Source electrode wiring 18-1 is connected to source terminal 20-1 through a wiring of aluminum, and source electrode wiring 18-2 is connected to source terminal 20-2 through a wiring of aluminum. Drain low-resistance region 21 of N$^+$-type impurity diffusion layer is formed in the second main surface area of semiconductor substrate 11. Drain electrode 22 is formed on substantially the entire portion of drain low-resistance region 21 in ohmic contact with region 21. Drain electrode 22 is connected to drain terminal 23.

In the semiconductor device of the above embodiment, two power MOSFETs 24-1 and 24-1 are selectively controlled by control signals S1 and S2 supplied to gate terminals 19-1 and 19-2.

With the above construction, two output signals are derived from one chip (semiconductor substrate 11). As a result, it becomes possible to drive two loads by use of one chip in response to control signals S1 and S2. Therefore, a mounting process on a PC board can be simplified, space for the mounting can be reduced and the number of parts used can be reduced. Further, since two power MOSFETs 24-1 and 24-2 for driving two loads are formed in the same chip, difference in the electrical and thermal characteristics between power MOSFETs 24-1 and 24-2 can be suppressed to a minimum, making it possible to drive the loads at a high precision.

In the device of Fig. 1, two power MOSFETs are formed in one chip, but it is of course possible to form more than two power MOSFETs in one chip according to the number of loads to be driven or as required.

Fig. 2 shows the construction of a vertical type power semiconductor device according to a second embodiment of this invention. In Fig. 2, this invention is applied to an insulated gate bipolar transistor (IGBT). In Fig. 2, portions which are substantially the same as those in Fig. 1 are denoted by the same reference numerals and the explanation thereof is omitted. As is well known in the art, an IGBT combines the high operation speed and high input impedance characteristics of the MOSFET and the high conductivity characteristics of the bipolar transistor. The device can be attained by using P$^+$-type impurity region 25 of high impurity concentration instead of drain low-resistance region 21 of MOSFETs 24-1 and 24-2 shown in Fig. 1. The resistance of drain high-resistance region (semiconductor substrate) 11 is lowered by holes injected therein from P$^+$-type impurity region 25. As a result, the same effect obtained in the case where N$^+$-type drain low-resistance region 21 is formed is attained. In other respects, this device is the same as the power MOSFET.

In the IGBT with the above construction, the same operation is effected as in the power MOSFET of Fig. 1 and the same effect can be attained.

In the first and second embodiments, the N-channel power MOSFET and IGBT are explained. However, if the conductivity types of the respective semiconductor regions are reversed (that is, P- and N-types are respectively changed to N- and P-types), P-channel power MOSFET and IGBT can be attained. Also, in this case, the same operation and effect can be attained except that the control voltage level is different.

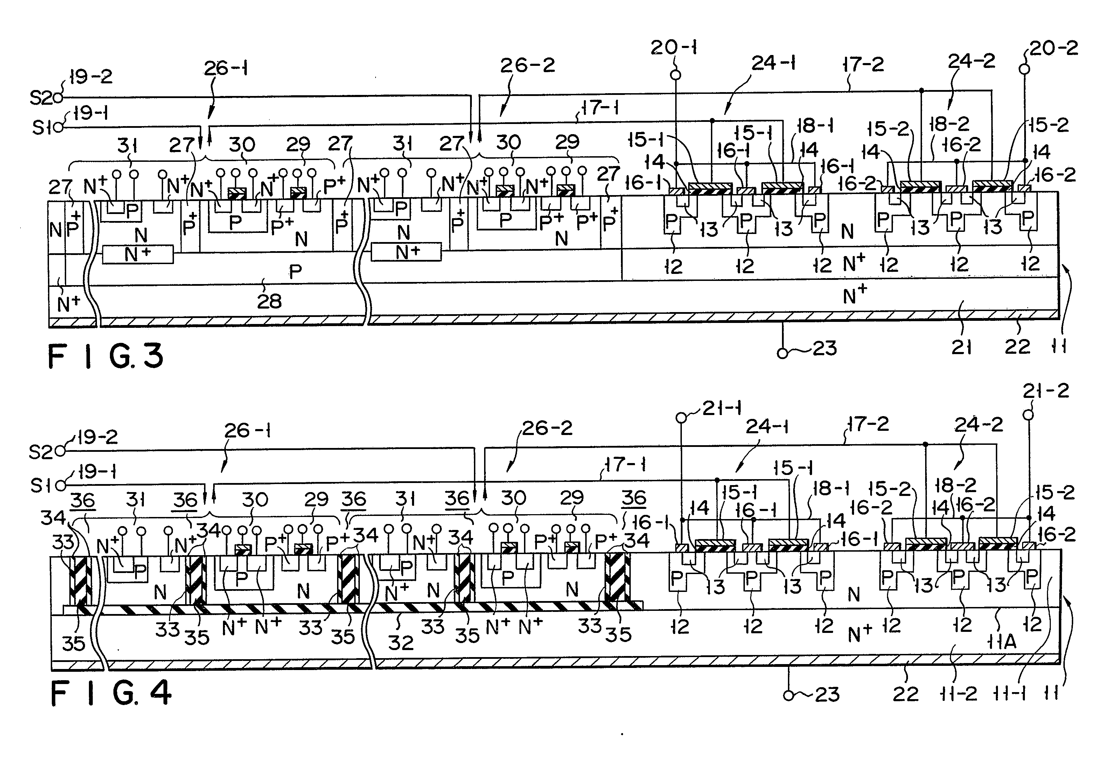

Fig. 3 shows a semiconductor device according to a third embodiment of this invention. The semiconductor device is a power IC in which power MOSFETs 24-1 and 24-2 of Fig. 1 and control circuits 26-1 and 26-2 for controlling power MOSFETs 24-1 and 24-2 and integrally formed in the same semiconductor substrate 11. Semiconductor elements constituting control circuits 26-1 and 26-2 are isolated from power MOSFETs 24-1 and 24-2 by the PN junction isolation method. That is, element formation regions are defined by P$^+$-type impurity region 27 formed for element isolation in the surface area of semiconductor substrate 11 and P-type epitaxial layer 28 formed for element isolation inside semiconductor substrate 11. Control circuits 26-1 and 26-2 for controlling power MOSFETs 24-1 and 24-2 are formed in the element formation regions. Each of control circuits 26-1 and 26-2 is constituted, for example, to include P-channel MOSFET 29, N-channel MOSFET 30, NPN bipolar transistor 31, and capacitor, diode, resistor and the like which are not shown. The semiconductor elements constituting control circuits 26-1 and 26-2 are operated on a signal voltage or signal current with a small amplitude.

In operation, a reverse bias voltage is applied between each of P$^+$-type impurity region 27 and P-type epitaxial layer 28 and N-type region (substrate 11) formed in contact thereto. As a result, a depletion layer is formed near the junction plane between the P-type region and the N-type region, thus isolating control circuits 26-1 and 26-1 and power MOSFETs 24-1 and 24-2 from each other. Control signal S1 supplied to gate terminal 19-1 is supplied to power MOSFET 24-1 via control circuit 26-1 and gate electrode wiring 17-1. Likewise, control signal S2 supplied to gate terminal 19-2 is supplied to power MOSFET 24-2 via control circuit 26-2 and gate electrode wiring 17-2. Control circuits 26-1 and 26-2 perform necessary processes according to control signals S1 and S2 to drive power MOSFETs 24-1 and 24-2.

Thus, two power MOSFETs 24-1 and 24-2 can be independently controlled by externally supplied control signals S1 and S2.

In the third embodiment, the power IC is explained in which control circuits 26-1 and 26-2 are isolated from power MOSFETs 24-1 and 24-2 by the PN junction isolation method. However, this invention can be applied to a power IC utilizing any type of element isolation technique. Fig. 4 shows a semiconductor device according to a fourth embodiment of this invention in which an dielectric isolation structure is used. The dielectric isolation structure is disclosed in, for example, Japanese Patent Disclosure (KOKAI) No. 62-76645. In this semiconductor device, various semiconductor elements are formed in composite substrate 11 formed of N-type semiconductor substrate 11-1 and N$^+$-type semiconductor substrate 11-2 fixed in close contact with each other. Silicon oxide film 32 is formed on that portion of N$^+$-type semiconductor substrate 11-2 or junction plane 11A between N-type semiconductor substrate 11-1 and N$^+$-type semiconductor substrate 11-2 over which control circuits 26-1 and 26-2 are to be formed. Grooves 33 are formed in semiconductor substrate 11-1 on silicon oxide film 32. Dielectric layer 36 formed of silicon oxide film 34 and polysilicon film 35 is formed in each of grooves 33. Element formation regions are formed by electrically isolating regions in which control circuits 26-1, 26-2 are to be formed in semiconductor substrate 11-1 from the remaining portion of semiconductor substrate 11 by means of dielectric layer 36 and silicon oxide film 32. Semiconductor elements such as P-channel MOSFET 29, N-channel MOSFET 30, NPN bipolar transistor 31, and capacitor, diode, resistor and the like (not shown) which constitute control circuits 26-1 and 26-2 are formed in the element formation regions.

With the above construction, the same operation and effect as those in the third embodiment can be attained.

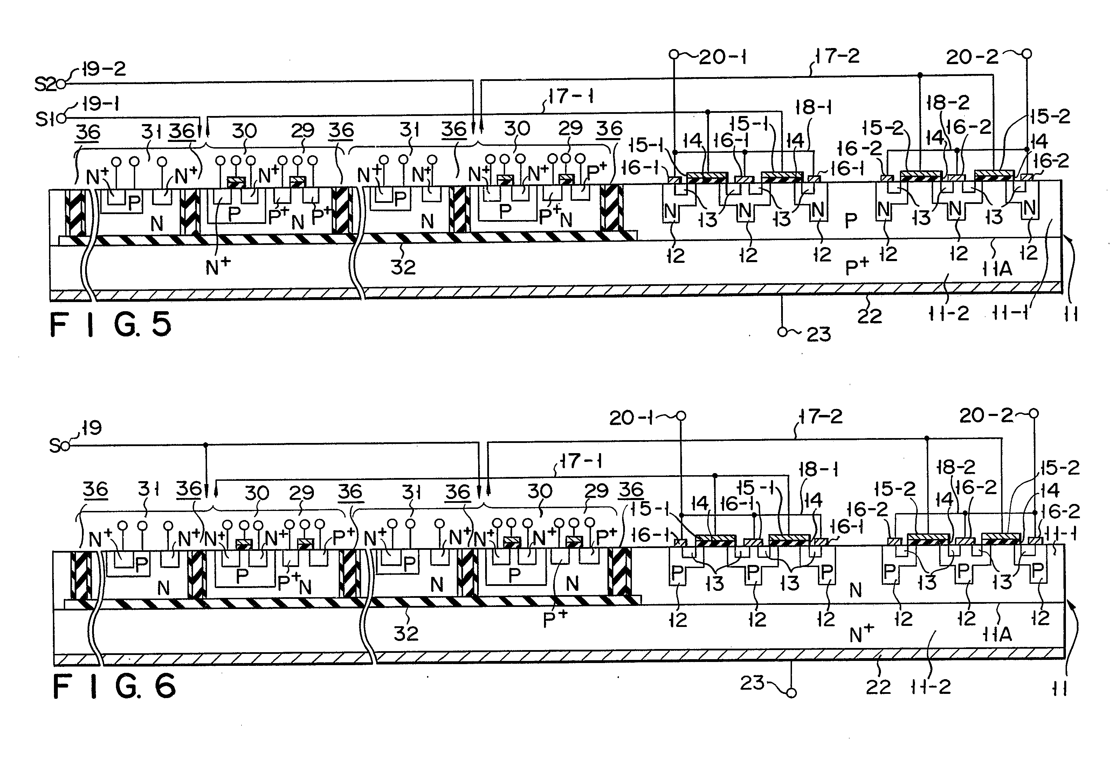

In the third and fourth embodiments, the power IC is formed to have the N-channel power MOSFET or N-channel IGBT. However, this invention can also be applied to a power IC having a P-channel MOSFET or P-channel IGBT. Fig. 5 shows a fifth embodiment of this invention which is a two-output power IC having a P-channel MOSFET. The construction of Fig. 5 corresponds to that of Fig. 4. The construction of Fig. 5 is similar to that of Fig. 4 except the conductivity types of the respective semiconductor regions, and therefore the detail explanation is omitted here. In this case, however, N-type semiconductor substrate 11-1, N$^+$-type semiconductor substrate 11-2, P body region 12 and N$^+$-type source region 13 are respectively replaced by P-type semiconductor substrate 11-1, P$^+$-type semiconductor substrate 11-2, N body region 12 and P$^+$-type source region 13.

With the construction of Fig. 5, the semiconductor device is made active by setting a voltage applied to gate electrodes 15-1 and 15-2 negative with respect to that applied to source electrodes 16-1 and 16-2.

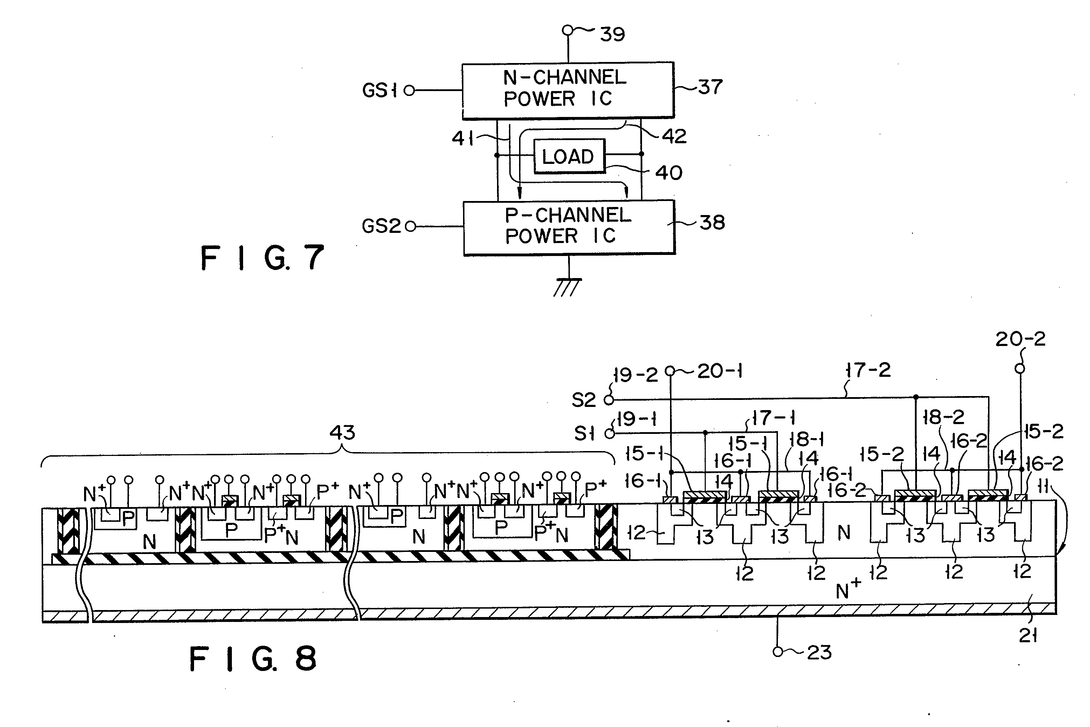

In the embodiments of Figs. 3 to 5, control signals S1 and S2 are supplied to control circuits 26-1 and 26-2 to control the operation of the semiconductor devices. However, as shown in Fig. 6, it is also possible to supply a single control signal S to control circuits 26-1 and 26-2 so as to control two power MOSFETs 24-1 and 24-2. In this case, control circuits 26-1 and 26-2 process a single signal to drive MOSFETs 24-1 and 24-2. Such a construction is suitable when an H-type bridge is formed as shown in Fig. 7. The H-type bridge is constructed to include two-output N-channel power IC 37 and two-output P-channel power IC 38. The drain of power IC 37 is connected to power source terminal 39, and the drain of power IC 38 is connected to the ground terminal. Two sources of power IC 37 are connected to those of power IC 38. Load 40 is connected between two connection nodes of the sources. The operation is controlled by control signals GS1 and GS2 supplied to power ICs 37 and 38. Load 40 is selectively supplied with one of currents flowing in a direction indicated by arrows 41 and 42 according to control signals GS1 and GS2.

As shown in Fig. 8, it is of course possible to form circuit 43 which is independent of power MOSFETs 24-1 and 24-2 in the same chip in which the power MOSFETs are formed.

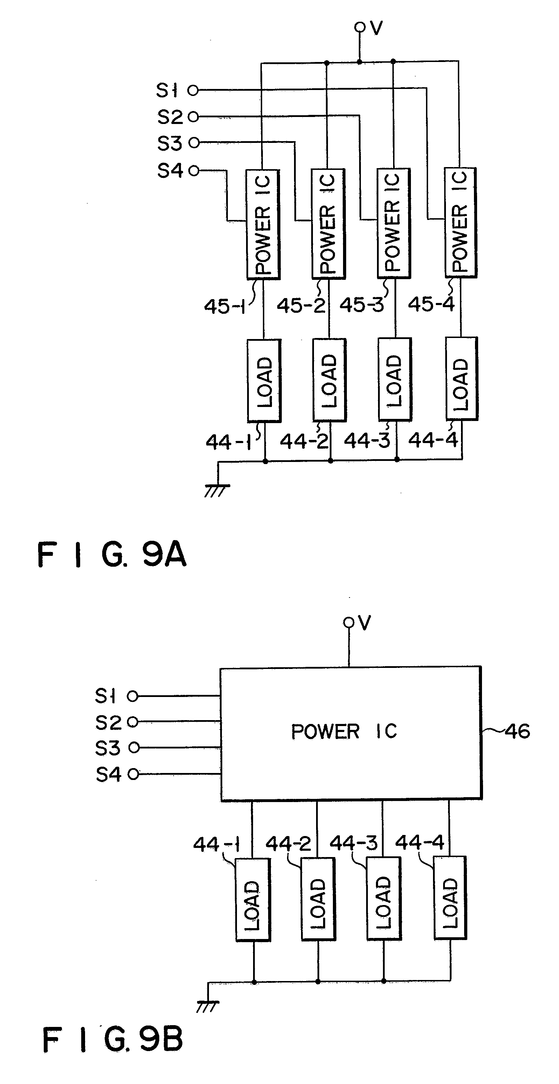

With this construction, since the power semiconductor device has a multi-output structure, a plurality of loads can be driven by the semiconductor devices formed in one chip. That is, in the conventional semiconductor device, for example, four chips (vertical type power semiconductor devices) are necessary for driving four loads 44-1 to 44-4 as shown in Fig. 9A. In contrast, in the embodiments of this invention, as shown in Fig. 9B, four loads 44-1 to 44-4 can be driven by one chip 46 by forming four devices (power MOSFETs or IGBTs) including four sets of gate electrode wirings and source electrode wirings. Thus, the mounting process on a PC board can be simplified, space for the mounting can be reduced and the number of parts used can be reduced. Further, since four devices for driving four loads 44-1 to 44-4 are formed in one chip, difference between the electrical and thermal characteristics of the devices can be suppressed to a minimum, thus making it possible to uniformly drive loads 44-1 to 44-4 at a high precision.

**Claims**

1. A vertical type power semiconductor device comprising a semiconductor substrate (11) of a first conductivity type acting as a drain region; a plurality of body regions (12) of a second conductivity type separately formed in a first main surface area of said semiconductor substrate (11); source regions (13) of the first conductivity type formed in the surface areas of said body regions (12) and having a high impurity concentration; a plurality of gate electrodes (15-1, 15-2) each formed on an insulation film (14) which is formed on that portion of said body region (12) which lies between the surface area of said semiconductor substrate (11) and said source region (13) and acts as a channel region; a plurality of source electrodes (16-1, 16-2) respectively formed in ohmic contact with said source regions (13); and a drain electrode (22) formed in ohmic contact with a second main surface of said semiconductor substrate (11); characterized by further comprising a plurality of gate electrode wirings (17-1, 17-2) for connecting said gate electrodes (15-1, 15-2) for each group; and a plurality of source electrode wirings (18-1, 18-2) for connecting said source electrodes (16-1, 16-2) in each of the groups divided by said gate electrode wirings (17-1, 17-2).

2. A semiconductor device according to claim 1, characterized in that said semiconductor substrate (11) has a low impurity concentration in the first main surface area and a high impurity concentration in the second main surface area (21).

3. A semiconductor device according to claim 1, characterized by further comprising an impurity region (25) of high impurity concentration of the second conductivity type formed in the second main surface area of said semiconductor substrate (11).

4. A power IC further comprising semiconductor circuits (26-1, 26-2) formed in said semiconductor substrate (11) and electrically isolated from said semiconductor device of claim 1.

5. A power IC according to claim 4, characterized in that said isolation between said semiconductor device and semiconductor circuits (26-1, 26-2) is attained by the PN junction isolation method.

6. A power IC according to claim 4, characterized in that said isolation between said semiconductor device and semiconductor circuits (26-1, 26-2) is attained by the dielectric isolation structure.

7. A power IC according to claim 4, characterized in that said semiconductor circuits (26-1, 26-2) are used to selectively control the gates of said semiconductor device via said plurality of gate electrode wirings (17-1, 17-2).

8. A power IC according to claim 7, characterized in that each of said semiconductor circuits (26-1, 26-2) is provided to each group of said gate electrode wirings (17-1, 17-2) and includes a plurality of transistors (29, 30, 31) for controlling the gates of said semiconductor device via said gate electrode wirings (17-1, 17-2).

F I G. 1

F I G. 2

EP 0 323 843 A2

F I G. 3

F I G. 4

EP 0 323 843 A2

FIG. 5

FIG. 6

EP 0 323 843 A2

EP 0 323 843 A2

39

| N-CHANNEL POWER IC | 37 |

GS1 ○—

41 — 42

LOAD 40

GS2 ○—

| P-CHANNEL POWER IC | 38 |

## F I G. 7

20-2

19-2 ○—20-1    17-2

S2 ○

19-1 ○    17-1

S1 ○    15-1    18-1    18-2    16-2    15-2

43    15-1    16-1    14    15-2    14    16-2    14

16-1    14    16-1    16-2    11

N⁺ N⁺N⁺ N⁺ P⁺ N⁺ N⁺N⁺ N⁺ P⁺

P N P P⁺N P N P P⁺N    12    13    13    N    13    13    12

12    12    N⁺    12    12    12

N⁺    21

○—23

## F I G. 8

F I G. 9A

F I G. 9B